# EUROPÄISCHE PATENTANMELDUNG

(11) **EP 2 276 073 A2**
(43) Veröffentlichungstag der Anmeldung: **19.01.2011**
(21) Anmeldenummer: 10183314.3
(22) Anmeldetag: 05.06.2002
(51) Int. Cl.: H01L 31/115, H01L 31/0288, H01L 27/146

(54) **Beidseitig mikrostrukturierter, ortsempfindlicher Detektor**

(30) Priorität: 15.06.2001 DE 10128654
(62) Teilanmeldung aus: 02764578.7
(71) Anmelder: Forschungszentrum Jülich GmbH, 52425 Jülich (DE)
(72) Erfinder: ProticC, Davor, 52428, Jülich (DE); Krings, Thomas, 52441, Linnich (DE); Schleichert, Ralf, 50170, Kerpen (DE)
(74) Vertreter: Gille Hrabal Struck Neidlein Prop Roos

(57) **Zusammenfassung**

Die Erfindung betrifft einen Detektor für die Orts- und/ oder Energiebestimmung von Photonen und/ oder geladenen Teilchen, mit einer Mehrzahl an Dioden aus einem Halbleitermaterial und n-Kontakten (1) und p-Kontakten (4), wobei die n-Kontakte durch Unterteilung einer n- Schicht in einzelne Segmente bereitgestellt sind. Die Segmente der n-Schicht sind 20 bis 500 µm breit.

Zur Herstellung des Detektors werden in ein Halbleitermaterial auf einer Seite Ionen zur Herstellung eines n-Kontaktes hinein diffundiert. Hierauf wird eine Metallschicht aufgedampft. Zur Segmentierung werden Gräben zwischen den Segmenten mittels Lithographie geätzt.

Es liegt ein besonders leistungsfähiger Detektor vor, der u. a. eine hohe Ortsauflösung und hohe Zählraten ermöglicht.

## Beschreibung

Die Erfindung betrifft einen Detektor für die Orts- und/ oder Energiebestimmung von Photonen und/ oder geladenen Teilchen. Dieser besteht aus einem Halbleitermaterial wie Silizium. Durch das halbleitende Material sowie durch segmentierte n- und p-Kontakte werden eine Vielzahl von Dioden bereitgestellt.

Ein aus Silizium bestehender Detektor der eingangs genannten Art ist aus der Druckschrift WO 97/33302 bekannt.

Grundsätzlich funktionieren solche Detektoren wie folgt. Ein geladenes Teilchen oder Photonen wie zum Beispiel Röntgen- oder Gamma-Quanten (γ-Quanten) treffen auf den aus Silizium bestehenden Detektor auf. Aufgrund der dann auftretenden Wechselwirkung zwischen dem geladenen Teilchen und dem Silizium bzw. zwischen dem Photon und dem Silizium entstehen im Silizium bewegliche, nicht an die Gitteratome gebundene Elektron-Loch-Paare, also bewegliche Ladungsträger. Die Anzahl der resultierenden Elektronen-Loch-Paare ist proportional zur Energie, die von dem aufgetroffenen geladenen Teilchen bzw. dem Photon abgegeben wurde.

Der Detektor umfasst Dioden nebst zugehörigen p- und n-Kontakten und steht während des Einsatzes unter Sperrspannung. Im elektrischen Feld des unter Sperrspannung stehenden Detektors werden die beweglichen Ladungsträger an den p- und n-Kontakten gesammelt. Dabei fließt ein elektrischer Strom. Die gesammelte Ladung ist ein Maß für die Energie des vorgenannten geladen Teilchens bzw. des Photons.

Die Erfindung betrifft Detektoren, die eine unterteilte n- bzw. p-Kontakte aufweisen. Diese sind mikrostrukturiert. Ein relativ großer n- oder p-Kontakt ist also in viele Elemente so unterteilt, dass jedes Element als unabhängiger Detektor wirkt. Jedes Element wird an einen ladungsempfindlichen Verstärker angebunden, um die Elemente einzeln auslesen zu können. Die Unterteilung ermöglicht es, den Ort zu bestimmen, an dem das geladene Teilchen oder das Photon auf den Detektor aufgetroffen ist. Je feiner die Unterteilung ist, desto besser ist die Ortsauflösung.

Ein Verstärker, der an ein einzelnes Element angebunden ist, kann nur bis zu einer geräteabhängigen maximalen Zählrate effektiv arbeiten. Hierdurch wird die Zahl der geladenen Teilchen bzw. Photonen begrenzt, die innerhalb einer Zeiteinheit bestimmt werden können. Wenn ein Detektor in n Elemente unterteilt ist, von denen jeder an einen eigenen Verstärker angeschlossen ist, kann die n-fache Zählrate bewältigt werden. Je feiner die Unterteilung ist, desto höhere Zählraten sind also möglich.

Ein Si(Li)-Detektor ist eine relativ dicke (2-10 mm) p-i-n-Diode aus Silizium. Der dünne (<1 µm) p-Kontakt wird durch Bor-Implantation oder Goldbedampfung realisiert. Über eine Lithium-Diffusion wird der dickere (10-500 µm) n-Kontakt hergestellt. Die einige mm dicke i-Zone wird in einem Driftprozess gewonnen, in dem die Lithium-Ionen die Akzeptoren in dem Ausgangsmaterial kompensieren.

Bis zu Dicken von circa 1 mm sind auf beiden Kontakten mikrostrukturierte, ortsauflösende Siliziumdetektoren kommerziell erhältlich. Eindimensionale Si(Li)-Streifendetektoren mit der vorgenannten Unterteilung bzw. Struktur auf der p⁺-Seite und mehr als 2 mm Dicke sind bekannt. Des weiteren ist eine zweidimensionale Ortsbestimmung mit Hilfe solcher Detektoren durch analoge Methoden (nicht segmentiert) Stand der Technik. Beidseitig digital-ortsempfindliche Si(Li)-Detektoren mit einer relativ groben Unterteilung der Kontakte (∼2 mm) sind seit 1973 bekannt [NIM 112 (1973) 455].

Bekannte Si(Li)-Detektoren weisen keine Mikrostrukturen auf dem Li-diffundierten Kontakt auf. Mit den bisherigen Methoden, die Segmentierung bzw. Unterteilung durch Sägen oder Fräsen des 100 bis 500 µm dicken Li-Kontaktes zu realisieren, können keine Strukturen kleiner als 1 mm gefertigt werden. Damit bleiben diese Detektoren auf den Einsatz bei niedrigen Teilchenraten und relativ geringer Ortsauflösung beschränkt. Außerdem weisen sie nur einen kleinen Dynamikbereich bei der kombinierten Teilchenidentifikation/Energiemessung auf.

Aufgabe der Erfindung ist die Schaffung eines leistungsfähigen Detektors mit Dioden, die p- und n- Kontakte aufweisen.

Die Aufgabe der Erfindung wird durch eine Detektor mit den Markmalen des Hauptanspruchs sowie durch ein Verfahren mit den Merkmalen des Nebenanspruchs gelöst. Vorteilhafte Ausgestaltungen ergeben sich aus den Unteransprüchen.

Der anspruchsgemäße Detektor für die Bestimmung von geladenen Teilchen oder Photonen weist eine Mehrzahl von Dioden mit p- und n-Kontakten auf. Die p- und n-Kontakte sind durch Unterteilung einer p- und einer n-Schicht in einzelne Segmente bereitgestellt worden. Die Segmente bei der n-Schicht sind 20 bis 1000 µm breit. Diese sind insbesondere lediglich 500 µm breit.

Im Unterschied zum Stand der Technik ist es gelungen, wesentlich kleinere Segmentierungen bei der problematischeren n-Schicht bereitzustellen. Aufgrund der kleineren Strukturen können im Vergleich zum Stand der Technik die eingangs genannten Verbesserungen erzielt werden. Der erfindungsgemäße Detektor ermöglicht also grundsätzlich unter anderem höhere Zählraten sowie eine verbesserte Ortsauflösung bei einer Messung.

Der Detektor besteht insbesondere aus Silizium. Der n-Kontakt ist bevorzugt mit Lithium dotiert und wurde beispielsweise durch Diffusion von Lithium in das Silizium hinein bereitgestellt. Insbesondere weist auch die p-Seite vergleichbar kleine Segmentierungen auf. Diese sind also bevorzugt nicht breiter als 1000 µm, insbesondere nicht breiter als 500 µm.

In einer weiteren Ausführungsform der Erfindung weisen die n-Schicht in maximal 1000 µm (insbesondere 500 µm) x 1000 µm (insbesondere 500 µm) große Segmente unterteilt. Die realisierbare Untergrenze liegt bei ca. 20 µm x 20 µm.

Um zu guten Ortsauflösungen zu gelangen, sind die Segmente auf der p- und n-Seite alternativ streifenförmig ausgebildet. Die Streifen auf der p-Seite verlaufen senkrecht relativ zu den Streifen auf der n-Seite.

Für die p-Schicht ist eine korrespondierende Segmentierung zu zweckmäßig.

Insbesondere bei den n-Kontakten sind die Segmente durch 10 bis 50 µm, bevorzugt durch 20 bis 30 µm breite Gräben voneinander getrennt. Dies ist das Resultat des erfindungsgemäßen Herstellungsprozesses.

Mit dem erfindungsgemäßen Detektor können geladene Teilchen mit Reichweiten von zum Beispiel bis zu 10 mm in Silizium identifiziert werden. Wenn ein Teilchen im Detektor gestoppt wird, so erzeugt es die meisten Ladungsträgerpaare am Endpunkt seiner Bahn. Von dort aus driften die positiven Ladungen zum einen Kontakt und die negativen Ladungsträger zum anderen. Die Differenz der Ankunftszeiten ist ein Maß für den Ort, an dem die Teilchen gestoppt wurden. Es werden also die Driftzeiten und die entsprechende aussagekräftige Differenz ermittelt. Wird ein Teilchen beispielsweise direkt an der Oberfläche des Detektors gestoppt, dann erreicht eine Ladungsträgersorte ihren Kontakt praktisch sofort, während die andere Sorte erst noch bis zum anderen Kontakt driften muss. Auf diese Weise bekommt man für gestoppte Teilchen aus der Differenz der Ankunftszeiten zusätzlich eine Information über Eindringtiefe bzw. die Weglänge, die das Teilchen im Silizium zurückgelegt hat.

Für geladene Teilchen hängt die vorgenannte Eindringtiefe von der Energie des Teilchens ab. Eine Auftragung der Teilchenenergie gegen seine Eindringtiefe ergibt für jede Teilchensorte eine eigene charakteristische Kurve. Durch Erstellung dieser Kurven ist ein einzelnes Teilchen identifizierbar. Die Teilchenidentifikation gelingt also durch Messung der Driftzeitdifferenzen. Mit dem erfindungsgemäßen Detektor kann ein großer Dynamikbereich im Vergleich zum Stand der Technik realisiert werden. Der erfindungsgemäße Detektor erfüllt also in besonders guter Weise die Anforderungen, die bei einer solchen Messung an den Detektor zu stellen sind.

Die einzelnen Segmente der n-Kontakte des Detektors können einzeln ausgelesen werden. Hieraus resultiert eine sehr gute Ortsauflösung von zum Beispiel besser als 500 µm x 100 µm. Hierfür sind streifenförmige Segmente auf der n-Seite 500 µm breit. Streifenförmige Segmente auf der p-Seite sind dann 100 µm breit. Die Streifen auf der p-Seite verlaufen orthogonal im Verhältnis zu den Streifen auf der n-Seite. Die maximal erzielbare Ortsauflösung hängt unmittelbar mit der Breite der streifenförmigen Segmente zusammen. Der Detektor erlaubt ferner den Betrieb bei hohen Zählraten.

Eine schnelle Ortsbestimmung (typischerweise 100 ns) für Triggerzwecke und zur Auflösung von Mehrdeutigkeiten ist beim erfindungsgemäßen Detektor möglich. Zwei oder mehr gleichzeitig einfallende Teilchen können in der Regel problemlos nachgewiesen werden. Eine dreidimensionale Ortsbestimmung (Δz-100µm) durch individuelle Driftzeitmessungen pro Segment mit Zeitauflösungen <10 ns FWHM ist möglich. Ein solche dreidimensionale Ortsbestimmung ist grundsätzlich bekannt, so zum Beispiel aus der Druckschrift "Nuclear Instruments and Methods in Physics Research, Section A, 452 (2000) 155-166 - "Three dimensional position sensing and field shaping in orthogonal-strip germanium-ray detectors", M. Amman, P.N. Luke).

Die Segmentierung des p⁺-implantierten Kontaktes mit Strukturen kleiner als 100 µm ist Stand der Technik, der beispielsweise in der Druckschrift "The Germanium Wall of the GEM Detector System, S. Igel, A. Hamacher, K. Kilian, H. Machner, D. Protic, R. V. Srikantiah, Acta Physika Polonika B, No. 2-3, Vol. 26(1995) beschrieben wird.

Die Mikrostrukturen auf dem durch Li-Diffusion wesentlich dickeren und daher problematischeren n-Kontaktes werden durch folgende Techniken realisiert: 20-30 µm dicke Li-diffundierte Kontakte werden durch eine Li-Diffusion erzeugt. Einzelheiten zur Durchführung eines derartigen Verfahrens zur Herstellung des n⁺-Kontaktes finden sich beispielsweise in der Druckschrift Si(Li) X-Ray Detectors with Amorphous Silicon Passivation, J. T. Walton, R. H. Pehl, Y. K. Wong, C. P. Cork, aus IEEE Transactions on Nuclear Science, Vol. NS-31, No. 1, February 1984, S. 331 - 335. Hier findet sich eine Beschreibung zu einem 10 µm dicken mit Li dotierten Kontakt. Die Dicke kann durch Einstellen der entsprechenden Parameter gezielt geändert werden. Zu beachtende Parameter sind insbesondere die Art und Weise, in der Lithium auf der Siliziumoberfläche aufgetragen wird, die während der Diffusion eingestellte Temperatur sowie die Dauer. Wird abgekühlt, so ist die Diffusion praktisch beendet. Mit zunehmender Temperaturen und/ oder längerer Dauer werden dickere Kontakte realisiert. Durch Abtragen einer Oberflächenschicht kann ferner erfindungsgemäß die gewünschte Dicke des n-Kontaktes gezielt eingestellt werden.

Die einzelnen Detektorsegmente werden durch circa 30 µm tiefe und circa 30 µm breite Gräben getrennt. Die Gräben werden photolithographisch definiert und durch Plasmaätzen hergestellt. Die einzelnen Schritte können wie folgt aussehen: Nach der Dotierung durch Implantation wird die dotierte Schicht mit einem elektrisch leitfähigen Material bedampft. Aluminium hat sich als elektrisch leitfähiges Material bewährt. Ein Photolack wird auf die aufgedampfte Schicht aufgetragen. Mittels Belichten durch eine Maske werden die gewünschten Strukturen vorgegeben. Der Photolack wird entwickelt. Durch die so entstanden Zugänge zur Aluminiumschicht wird das Aluminium hier entfernt und anschließend durch Ätzen in das Siliziummaterial bis zur gewünschten Tiefe fortgesetzt. Der Photolack wird entfernt und die verbliebenen Aluminiumsegmente elektrisch kontaktiert.

Diese Technik erlaubt problemlos Strukturen kleiner als 1000 µm und ist grundsätzlich aus den Druckschriften [NIM 226 (1984) 103-106], [NIM A 462/3 364 (2001)] bekannt.

### Ausführungsbeispiel:

Ein Si(Li)-Detektor ist eine relativ dicke (2-10 mm) p-i-n-Diode aus Silizium. Der dünne (<1 µm) p-Kontakt wird durch Bor-Implantation oder Goldbedampfung realisiert. Über eine Lithium-Diffusion wird der dickere (10-500 µm) n-Kontakt hergestellt. Die einige mm dicke i-Zone wird in einem Driftprozess gewonnen, in dem die Lithium-Ionen die Akzeptoren in dem Ausgangsmaterial kompensieren.

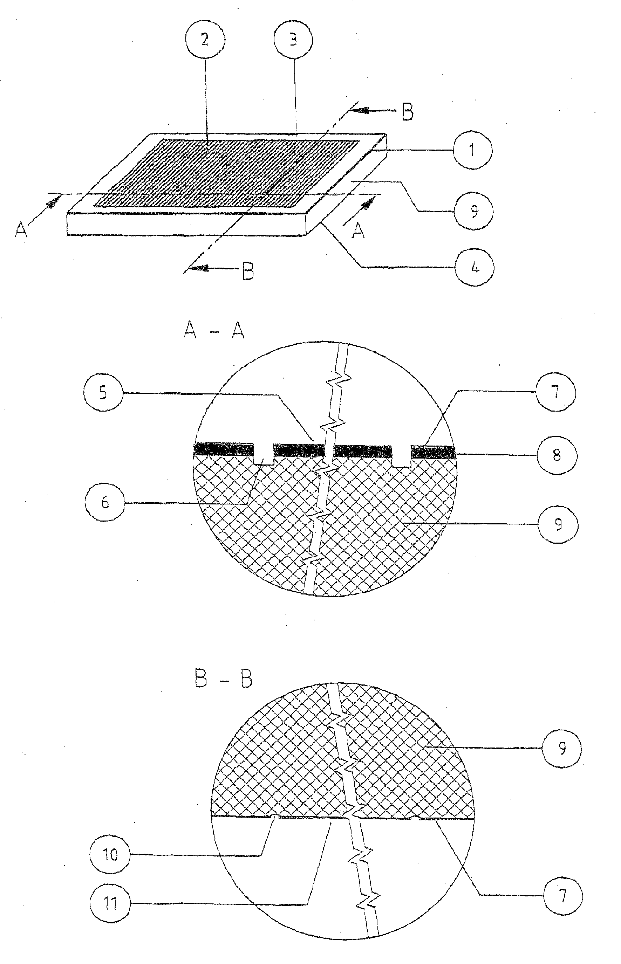

Eine 60 x 60 mm² große und 5 mm dicke Si(Li)-Diode wurde so hergestellt. Diese wird in der Figur dargestellt. Die Dicke des Li-diffundierten Kontaktes (1, 8) beträgt 30 µm. Eine aufgedampfte Aluminium-Schicht (7), 0,3 µm dick, erhöht die Leitfähigkeit der Li-diffundierten Schicht.

Durch die Photolithographie wurden die Gräben (6, 10) bzw. die ortsempfindliche Struktur definiert. In diesem Falle sind es 50 Streifen (circa 1 mm breit) auf einer Fläche von 50 x 50 mm². Nach dem Auflösen der Aluminiumschicht und anschließendem tiefen Plasmaätzen entstehen ca. 40 µm tiefe und ca. 50 µm breite Gräben. Auf die Weise sind die einzelnen Detektorelemente durch die Gräben getrennt. Dieses Verfahren ermöglicht die Herstellung von ortsempfindlichen Strukturen in beliebiger Form. Beispielsweise sind Spiralformen bei der Segmentierung möglich. Die Strukturierung der p⁺-Seite (4,10,11) verläuft ähnlich.

Die Bezugszeichen bedeuten: 1: n⁺-Kontakt (mittels Lithium - Diffusion erzeugt); 2: Struktur (in diesem Fall 50 Streifen mit einer Periodizität von 1 mm und einer Streifenlänge von 50 mm); 3: Guard-Ring des Lithium-diffundierten Kontakts; 4: p⁺-Kontakt (durch Bor-Implantation erzeugt) mit gleicher Struktur wie beim n⁺-Kontakt (orthogonal zur Struktur des n⁺-Kontakts); 5: Detektorelement (in diesem Fall: Streifen von 950 µm Breite); 6: Graben (in diesem Fall 50 µm breit und 40 µm tief); 7: Aluminiumschicht; 8: durch Lithium-Diffusion bereitgestellter Kontakt; 9: mit Lithium kompensiertes Silizium; 10: Graben (in diesem Fall 20µm breit und 5 µm tief); 11: Detektorelement (in diesem Fall Streifen von 980 µm Breite).

## Patentansprüche

1. Detektor für die Orts- und/ oder Energiebestimmung von Photonen und/ oder geladenen Teilchen, mit einer Mehrzahl an Dioden aus einem Halbleitermaterial und n-Kontakten (1) und p-Kontakten (4), wobei die n-Kontakte durch Unterteilung einer n- Schicht in einzelne Segmente bereitgestellt sind
**dadurch gekennzeichnet, dass**
die Segmente der n-Schicht 20 bis 1000 µm, bevorzugt bis 500 µm breit sind.

2. Detektor nach Anspruch 1, bei dem das Halbleitermaterial Silizium ist und/ oder die n-Kontakt-Segmente (1) mit Lithium dotiert sind.

3. Detektor nach Anspruch 1 oder 2, bei dem Segmente auf der Seite mit den p-Kontakten (4) nicht breiter als 500 µm, insbesondere nicht breiter als 100 µm sind und insbesondere streifenförmig sowie orthogonal zu streifenförmigen Segmenten der n-Kontakte verlaufen.

4. Detektor nach einem der vorhergehenden Ansprüche, bei dem die Segmente auf der Seite mit den n-Kontakten (1) maximal 1000 µm x 1000 µm, bevorzugt maximal 500 µm x 500 µm groß sind.

5. Detektor nach einem der vorhergehenden Ansprüche, bei dem die Segmente auf der Seite mit den n-Kontakten durch - insbesondere 10 bis 50 µm, bevorzugt durch 20 bis 30 µm breite - Gräben (6) voneinander getrennt sind.

6. Detektor nach einem der vorhergehenden Ansprüche, bei dem die n-Kontakte (1) mit einer metallischen Schicht (7) bedampft sind.

7. Detektor nach einem der vorhergehenden Ansprüche, bei dem jeder n-Kontakt (1) mit je einem Verstärker verbunden ist.

8. Verfahren zur Herstellung eines Detektor nach einem der vorhergehenden Ansprüche, bei dem in ein Halbleitermaterial auf einer Seite Ionen zur Herstellung eines n-Kontaktes implantiert werden, hierauf eine Metallschicht aufgedampft wird, und zur Segmentierung Gräben zwischen den Segmenten mittels Lithographie geätzt werden.
